# EUROPÄISCHE PATENTSCHRIFT

(11) **EP 3 729 648 B1**
(45) Veröffentlichungstag und Bekanntmachung des Hinweises auf die Patenterteilung: **24.05.2023**
(21) Anmeldenummer: 18704472.2
(22) Anmeldetag: 31.01.2018
(51) Int. Cl.: H03K 17/0414, H03K 17/16, H03K 17/0812

(54) **VERFAHREN ZUM EINSCHALTEN EINES LEISTUNGSHALBLEITERBAUELEMENTS**
METHOD FOR SWITCHING ON A POWER SEMICONDUCTOR COMPONENT
PROCÉDÉ D'ACTIVATION D'UN COMPOSANT À SEMI-CONDUCTEUR DE PUISSANCE

(43) Veröffentlichungstag der Anmeldung: 28.10.2020
(73) Patentinhaber: Siemens Energy Global GmbH & Co. KG, 81739 München (DE)
(72) Erfinder: LIZAMA ARCOS, Ignacio Esteban, 90441 Nürnberg (DE); ALVAREZ VALENZUELA, Rodrigo Alonso, 90408 Nürnberg (DE); BERNET, Steffen, 01454 Radeberg (OT Ullersdorf) (DE); GAMBACH, Herbert, 91080 Uttenreuth (DE); SCHUSTER, Dominik, 91456 Diespeck (DE); SEMMLER, Sebastian, 90427 Nürnberg (DE)
(86) Internationale Anmeldenummer: PCT/EP2018/052371
(87) Internationale Veröffentlichungsnummer: WO 2019/149347

(56) Entgegenhaltungen:
- EP-A1- 2 418 776
- EP-A1- 2 424 112
- DE-A1-102010 032 717
- DE-B3-102013 015 723

## Beschreibung

Die Erfindung betrifft ein Verfahren zum Einschalten eines bipolaren schaltbaren Leistungshalbleiterbauelements und eine Ansteuerschaltung für ein bipolares schaltbares Leistungshalbleiterbauelement.

Aus der Offenlegungsschrift DE 10 2010 032 717 A1 ist eine elektrische Schaltung zum Betreiben eines als IGBT ausgestalteten Leistungshalbleiterbauelements bekannt. Bei einem Einschaltvorgang steigt die Gate-Emitter-Spannung des IGBT an und erreicht eine im Wesentlichen konstant bleibende Plateau-Spannung. Erst danach steigt die Gate-Emitter-Spannung auf die Spannung für den stationären Zustand des IGBT.

Die europäische Patentanmeldung EP 2 424 112 A1 offenbart ein Verfahren und eine Anordnung zum Ausbalancieren des Schaltübergangsverhaltens von elektrisch parallel geschalteten Leistungshalbleiterbauelementen.

Es hat sich herausgestellt, dass es vorteilhaft ist, bipolare schaltbare Leistungshalbleiterbauelemente, insbesondere Bipolartransistoren mit isolierter Gate-Elektrode, mit vergleichsweise großen Gate-Emitter-Spannungen zu betreiben. Früher wurden lediglich Gate-Emitter-Spannungen von maximal 15 V zur Ansteuerung der Leistungshalbleiterbauelemente verwendet. Es hat sich aber gezeigt, dass Gate-Emitter-Spannungen größer oder gleich 18 Volt vorteilhaft sind, weil bei derartigen Gate-Emitter-Spannungen die Durchlassverluste der Leistungshalbleiterbauelemente verringert sind. Allerdings wirft das Betreiben von Leistungshalbleiterbauelementen mit derartig hohen Gate-Emitter-Spannungen Schwierigkeiten auf: Wenn beispielsweise ein Leistungshalbleiterbauelement bei einem bereits existierenden Kurzschluss eingeschaltet wird (sogenannter Typ-1-Kurzschluss), dann können sehr hohe Kurzschlussströme entstehen, welche im Extremfall das Leistungshalbleiterbauelement zerstören können.

Der Erfindung liegt die Aufgabe zugrunde, ein Verfahren zum Einschalten eines bipolaren schaltbaren Leistungshalbleiterbauelements sowie eine Ansteuerschaltung für ein bipolares schaltbares Leistungshalbleiterbauelement anzugeben, bei denen auch bei Nutzung von Gate-Emitter-Spannungen größer oder gleich 18 Volt ein Auftreten von unzulässig hohen Kurzschlussströmen vermieden werden kann.

Diese Aufgabe wird erfindungsgemäß gelöst durch ein Verfahren und durch eine Ansteuerschaltung nach den unabhängigen Patentansprüchen. Vorteilhafte Ausführungsformen des Verfahrens und der Ansteuerschaltung sind in den abhängigen Patentansprüchen angegeben.

Offenbart wird ein Verfahren zum Einschalten eines bipolaren schaltbaren Leistungshalbleiterbauelements, bei dem
- in einem ersten Zeitabschnitt die Gate-Emitter-Spannung des Leistungshalbleiterbauelements mit einer ersten mittleren Spannungsänderungsgeschwindigkeit bis zu einem ersten Spannungswert erhöht wird,
- danach in einem zweiten Zeitabschnitt die Gate-Emitter-Spannung konstant gehalten oder bis zu einem zweiten Spannungswert erhöht wird, wobei die Gate-Emitter-Spannung in dem zweiten Zeitabschnitt eine zweite mittlere Spannungsänderungsgeschwindigkeit aufweist, die kleiner ist als die erste mittlere Spannungsänderungsgeschwindigkeit, und
- danach in einem dritten Zeitabschnitt die Gate-Emitter-Spannung mit einer dritten mittleren Spannungsänderungsgeschwindigkeit bis zu einem dritten Spannungswert erhöht wird, wobei die dritte mittlere Spannungsänderungsgeschwindigkeit größer ist als die zweite mittlere Spannungsänderungsgeschwindigkeit und der dritte Spannungswert größer als oder gleich 18V ist.

Hierbei ist besonders vorteilhaft, dass die Gate-Emitter-Spannung zunächst mit der ersten mittleren Spannungsänderungsgeschwindigkeit bis zu dem ersten Spannungswert erhöht wird und danach im zweiten Zeitabschnitt die Gate-Emitter-Spannung konstant gehalten oder mit der zweiten mittleren Spannungsänderungsgeschwindigkeit nur wenig erhöht wird. Der zweite Zeitabschnitt stellt also einen Warte-Zeitabschnitt dar, bevor die Gate-Emitter-Spannung bis zu dem dritten Spannungswert erhöht wird. Dadurch wird das Leistungshalbleiterbauelement zunächst mit dem ersten Spannungswert der Gate-Emitter-Spannung eingeschaltet. Falls dieses Einschalten bereits auf einen existierenden Kurzschluss trifft, dann wird (aufgrund des ersten geringeren Spannungswertes) nur ein vergleichsweise geringer Kurzschlussstrom auftreten. Dieser Kurzschlussstrom kann während des zweiten Zeitabschnitts mit herkömmlichen Kurzschluss-Erkennungsmethoden erkannt werden, woraufhin das Verfahren zum Einschalten des Leistungshalbleiterbauelements abgebrochen wird. Erst nachdem der zweite Zeitabschnitt beendet ist, wird die Gate-Emitter-Spannung auf den dritten Spannungswert erhöht, bei dem dann die vorteilhaften Effekte wie beispielsweise die verringerten Durchlassverluste auftreten.

Das Verfahren läuft also so ab, dass während des zweiten Zeitabschnitts festgestellt wird, ob durch das Leistungshalbleiterbauelement bereits ein unzulässig großer Strom (Kurzschlussstrom) fließt und nur dann zu dem dritten Zeitabschnitt übergegangen wird, wenn kein unzulässig großer Strom festgestellt worden ist. Wenn ein unzulässig großer Strom festgestellt wird, wird die Erhöhung der Gate-Emitter-Spannung abgebrochen. Wenn in dem zweiten Zeitabschnitt die Gate-Emitter-Spannung konstant gehalten wird, dann ist die zweite mittlere Spannungsänderungsgeschwindigkeit Null. Das Leistungshalbleiterbauelement kann insbesondere ein IGBT sein.

Das Verfahren kann so ablaufen, dass die zweite mittlere Spannungsänderungsgeschwindigkeit mindestens um den Faktor 5 kleiner ist als die erste mittlere Spannungsänderungsgeschwindigkeit.

Das Verfahren kann auch so ablaufen, dass die zweite mittlere Spannungsänderungsgeschwindigkeit mindestens um den Faktor 5 kleiner ist als die dritte mittlere Spannungsänderungsgeschwindigkeit.

Durch diese Ausgestaltungsarten des Verfahrens wird sichergestellt, dass die zweite mittlere Spannungsänderungsgeschwindigkeit deutlich kleiner ist als die erste mittlere Spannungsänderungsgeschwindigkeit und die dritte mittlere Spannungsänderungsgeschwindigkeit. Dadurch wird ein deutlich abgegrenzter zweiter (Warte-)Zeitabschnitt erreicht.

Das Verfahren kann so ablaufen, dass die zweite mittlere Spannungsänderungsgeschwindigkeit zwischen 0 und 1 V/µs, insbesondere zwischen 0,01 und 1 V/µs, liegt. Dies ist eine relativ geringe Spannungsänderungsgeschwindigkeit. Wenn die zweite mittlere Spannungsänderungsgeschwindigkeit Null beträgt, dann bleibt die Gate-Emitter-Spannung in dem zweiten Zeitabschnitt konstant.

Das Verfahren kann auch so ablaufen, dass der zweite Zeitabschnitt zwischen 2 und 100 µs, insbesondere zwischen 10 und 100 µs, lang ist. Der zweite Zeitabschnitt kann auch zwischen 2 und 50 us lang sein. Der zweite Zeitabschnitt ist ein Warte-Zeitabschnitt, bevor die Gate-Emitter-Spannung bis zu dem dritten Spannungswert erhöht wird.

Das Verfahren kann so ablaufen, dass der dritte Spannungswert der Gate-Emitter-Spannung des Leistungshalbleiterbauelements im (stationären) eingeschalteten Zustand entspricht. In diesem eingeschalteten Zustand treten die vorteilhaften Wirkungen der erhöhten Gate-Emitter-Spannung auf, insbesondere die verringerten Durchlassverluste des Leistungshalbleiterbauelements.

Das Verfahren kann auch so ablaufen, dass der dritte Spannungswert zwischen 18 und 35 V beträgt. Es hat sich herausgestellt, dass bei diesen Spannungswerten eine deutliche Verringerung der Durchlassverluste des Leistungshalbleiterbauelements vorliegt.

Das Verfahren kann ein Verfahren zum Einschalten eines Leistungshalbleiterbauelements eines Moduls eines modularen Multilevelstromrichters sein, wobei der modulare Multilevelstromrichter eine Vielzahl von Modulen aufweist, die eine elektrische Reihenschaltung bilden, die Module jeweils mindestens das Leistungshalbleiterbauelement, ein zweites Leistungshalbleiterbauelement und einen elektrischen Energiespeicher aufweisen, wobei das Leistungshalbleiterbauelement und das zweite Leistungshalbleiterbauelement in einer Halbbrückenschaltung angeordnet sind, oder die Module jeweils mindestens das Leistungshalbleiterbauelement, ein zweites Leistungshalbleiterbauelement, ein drittes Leistungshalbleiterbauelement, ein viertes Leistungshalbleiterbauelement und einen elektrischen Energiespeicher aufweisen, wobei das Leistungshalbleiterbauelement, das zweite Leistungshalbleiterbauelement, das dritte Leistungshalbleiterbauelement und das vierte Leistungshalbleiterbauelement in einer Vollbrückenschaltung angeordnet sind. Das Verfahren lässt sich also vorteilhaft bei einem modularen Multilevel-Stromrichter anwenden.

Das Verfahren kann so ausgestaltet sein, dass die Gate-Emitter-Spannung ausgehend von einem (maximalen) negativen Spannungswert bis zu dem dritten Spannungswert erhöht wird, wobei der Betrag des dritten Spannungswerts größer ist als der Betrag des negativen Spannungswerts. Dadurch kann ein sicherer Übergang vom ausgeschalteten Zustand des Leistungshalbleiterbauelements zum eingeschalteten Zustand des Leistungshalbleiterbauelements erreicht werden.

Das Verfahren kann so ablaufen, dass das bipolare schaltbare Leistungshalbleiterbauelement ein Bipolartransistor mit isolierter Gate-Elektrode (IGBT) ist.

Offenbart wird weiterhin eine Ansteuerschaltung für ein bipolares schaltbares Leistungshalbleiterbauelement, die zum Ausgeben einer Gate-Emitter-Spannung für das Leistungshalbleiterbauelement eingerichtet ist, wobei
- die Gate-Emitter-Spannung in einem ersten Zeitabschnitt mit einer ersten mittleren Spannungsänderungsgeschwindigkeit bis zu einem ersten Spannungswert ansteigt,
- danach die Gate-Emitter-Spannung in einem zweiten Zeitabschnitt konstant bleibt oder bis zu einem zweiten Spannungswert ansteigt, wobei die Gate-Emitter-Spannung in dem zweiten Zeitabschnitt eine zweite mittlere Spannungsänderungsgeschwindigkeit aufweist, die kleiner ist als die erste mittlere Spannungsänderungsgeschwindigkeit, und
- danach die Gate-Emitter-Spannung in einem dritten Zeitabschnitt mit einer dritten mittleren Spannungsänderungsgeschwindigkeit bis zu einem dritten Spannungswert ansteigt, wobei die dritte mittlere Spannungsänderungsgeschwindigkeit größer ist als die zweite mittlere Spannungsänderungsgeschwindigkeit und der dritte Spannungswert größer als oder gleich 18V ist. Wenn in dem zweiten Zeitabschnitt die Gate-Emitter-Spannung konstant gehalten wird, dann ist die zweite mittlere Spannungsänderungsgeschwindigkeit Null.

Die Ansteuerschaltung kann so ausgestaltet sein, dass die zweite mittlere Spannungsänderungsgeschwindigkeit mindestens um den Faktor 5 kleiner ist als die erste mittlere Spannungsänderungsgeschwindigkeit.

Die Ansteuerschaltung kann auch so ausgestaltet sein, dass die zweite mittlere Spannungsänderungsgeschwindigkeit mindestens um den Faktor 5 kleiner ist als die dritte mittlere Spannungsänderungsgeschwindigkeit.

Die Ansteuerschaltung kann so ausgestaltet sein, dass die zweite mittlere Spannungsänderungsgeschwindigkeit zwischen 0 und 1 V/ps, insbesondere zwischen 0,01 und 1 V/µs, liegt.

Die Ansteuerschaltung kann auch so ausgestaltet sein, dass der zweite Zeitabschnitt zwischen 2 und 100 µs, insbesondere zwischen 10 und 100 µs, lang ist. Der zweite Zeitabschnitt kann auch zwischen 2 und 50 us lang sein.

Die Ansteuerschaltung kann so ausgestaltet sein, dass die Gate-Emitter-Spannung des Leistungshalbleiterbauelements im (stationären) eingeschalteten Zustand dem dritten Spannungswert entspricht.

Die Ansteuerschaltung kann so ausgestaltet sein, dass der dritte Spannungswert zwischen 18 und 35 V beträgt.

Die Ansteuerschaltung kann so ausgestaltet sein, dass die Gate-Emitter-Spannung ausgehend von einem (maximalen) negativen Spannungswert bis zu dem dritten Spannungswert ansteigt, wobei der Betrag des dritten Spannungswerts größer ist als der Betrag des negativen Spannungswerts.

Die Ansteuerschaltung kann so ausgestaltet sein, dass das bipolare schaltbare Leistungshalbleiterbauelement ein Bipolartransistor mit isolierter Gate-Elektrode (IGBT) ist.

Offenbart wird weiterhin eine Leistungshalbleitereinheit mit einem bipolaren schaltbaren Leistungshalbleiterbauelement, insbesondere mit einem Bipolartransistor mit isolierter Gate-Elektrode, und mit einer Ansteuerschaltung nach einer der vorstehend beschriebenen Ausführungsformen.

Die Leistungshalbleitereinheit kann so ausgestaltet sein, dass das bipolare schaltbare Leistungshalbleiterbauelement ein Bipolartransistor mit isolierter Gate-Elektrode ist.

Offenbart wird weiterhin ein Modul eines modularen Multilevelstromrichters mit einer solchen Leistungshalbleitereinheit. Der modulare Multilevelstromrichter kann eine Vielzahl von solchen Modulen aufweisen, die eine elektrische Reihenschaltung bilden. Dabei können die Module jeweils mindestens ein Leistungshalbleiterbauelement, ein zweites Leistungshalbleiterbauelement und einen elektrischen Energiespeicher aufweisen, wobei das Leistungshalbleiterbauelement und das zweite Leistungshalbleiterbauelement in einer Halbbrückenschaltung angeordnet sind, oder die Module können jeweils mindestens ein Leistungshalbleiterbauelement, ein zweites Leistungshalbleiterbauelement, ein drittes Leistungshalbleiterbauelement, ein viertes Leistungshalbleiterbauelement und einen elektrischen Energiespeicher aufweisen, wobei das Leistungshalbleiterbauelement, das zweite Leistungshalbleiterbauelement, das dritte Leistungshalbleiterbauelement und das vierte Leistungshalbleiterbauelement in einer Vollbrückenschaltung angeordnet sind.

Die Ansteuerschaltung, die Leistungshalbleitereinheit und/oder das Modul des modularen Multilevelstromrichters weisen gleichartige Vorteile auf, wie sie oben im Zusammenhang mit dem Verfahren beschrieben sind.

Im Folgenden wird die Erfindung anhand von Ausführungsbeispielen näher erläutert. Gleiche Bezugszeichen verweisen dabei auf gleiche oder gleichwirkende Elemente. Dazu ist in
- Figur 1: ein erstes Ausführungsbeispiel eines modularen Multilevelstromrichters, in
- Figur 2: ein zweites Ausführungsbeispiel eines modularen Multilevelstromrichters, in
- Figur 3: ein Ausführungsbeispiel eines Phasenmodulzweigs eines modularen Multilevelstromrichters, in
- Figur 4: ein Ausschnitt aus dem Phasenmodulzweig der Figur 3, in
- Figur 5: ein Ausführungsbeispiel eines Moduls eines modularen Multilevelstromrichters, in
- Figur 6: ein weiteres Ausführungsbeispiel eines Moduls eines modularen Multilevelstromrichters, in
- Figur 7: ein Ausführungsbeispiel einer Leistungshalbleitereinheit mit einem Leistungshalbleiterbauelement und einer Ansteuerschaltung, in
- Figur 8: ein beispielhafter Verlauf des Einschaltens eines Leistungshalbleiterbauelements, und in
- Figur 9: ein Detail eines weiteren Ausführungsbeispiels eines Einschaltens eines Leistungshalbleiterbauelements
dargestellt.

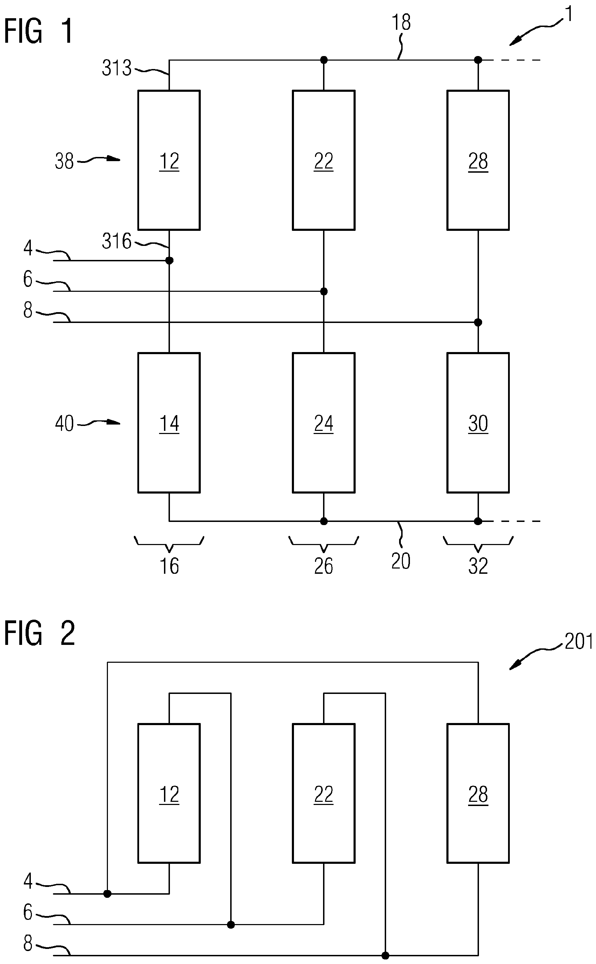

In Figur 1 ist ein Ausführungsbeispiel eines modularen Multilevelstromrichters 1 in Brückenschaltung dargestellt. Dieser modulare Multilevelstromrichter 1 weist einen ersten Wechselstromanschluss 4, einen zweiten Wechselstromanschluss 6 und einen dritten Wechselstromanschluss 8 auf. Der erste Wechselstromanschluss 4, der zweite Wechselstromanschluss 6 und der dritte Wechselstromanschluss 8 sind mit einem dreiphasigen Wechselstromnetz verbindbar.

Der erste Wechselstromanschluss 4 ist elektrisch mit einem ersten Phasenmodulzweig 12 und einem zweiten Phasenmodulzweig 14 verbunden. Der erste Phasenmodulzweig 12 und der zweite Phasenmodulzweig 14 bilden ein erstes Phasenmodul 16 des Stromrichters 1. Das dem ersten Wechselstromanschluss 4 abgewandte Ende des ersten Phasenmodulzweigs 12 ist mit einem ersten Gleichspannungsanschluss 18 elektrisch verbunden; das dem ersten Wechselstromanschluss 4 abgewandte Ende des zweiten Phasenmodulzweigs 14 ist mit einem zweiten Gleichspannungsanschluss 20 elektrisch verbunden. Der erste Gleichspannungsanschluss 18 ist ein positiver Gleichspannungsanschluss; der zweite Gleichspannungsanschluss 20 ist ein negativer Gleichspannungsanschluss. Zwischen dem ersten Gleichspannungsanschluss 18 und dem zweiten Gleichspannungsanschluss 20 liegt eine Gleichspannung Ud an.

Der zweite Wechselstromanschluss 6 ist mit einem Ende eines dritten Phasenmodulzweigs 22 und mit einem Ende eines vierten Phasenmodulzweigs 24 elektrisch verbunden. Der dritte Phasenmodulzweig 22 und der vierte Phasenmodulzweig 24 bilden ein zweites Phasenmodul 26. Der dritte Wechselstromanschluss 8 ist mit einem Ende eines fünften Phasenmodulzweigs 28 und mit einem Ende eines sechsten Phasenmodulzweigs 30 elektrisch verbunden. Der fünfte Phasenmodulzweig 28 und der sechste Phasenmodulzweig 30 bilden ein drittes Phasenmodul 32.

Das dem zweiten Wechselstromanschluss 6 abgewandte Ende des dritten Phasenmodulzweigs 22 und das dem dritten Wechselstromanschluss 8 abgewandte Ende des fünften Phasenmodulzweigs 2827 sind mit dem ersten Gleichspannungsanschluss 18 elektrisch verbunden. Das dem zweiten Wechselstromanschluss 6 abgewandte Ende des vierten Phasenmodulzweigs 24 und das dem dritten Wechselstromanschluss 8 abgewandte Ende des sechsten Phasenmodulzweigs 30 sind mit dem zweiten Gleichspannungsanschluss 20 elektrisch verbunden. Der erste Phasenmodulzweig 12, der dritte Phasenmodulzweig 22 und der fünfte Phasenmodulzweig 28 bilden ein positivseitiges Stromrichterteil 38; der zweite Phasenmodulzweig 14, der vierte Phasenmodulzweig 23 und der sechste Phasenmodulzweig 30 bilden ein negativseitiges Stromrichterteil 40.

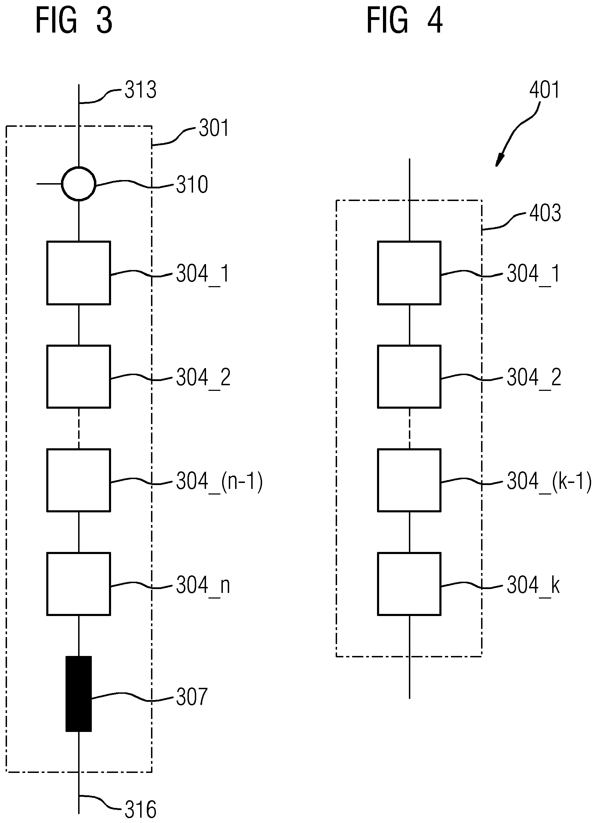

Jeder Phasenmodulzweig weist eine Mehrzahl von Modulen, welche elektrisch in Reihe geschaltet sind, vergleiche auch Figur 3. Solche Module werden auch als Submodule bezeichnet. Im Ausführungsbeispiel weist jeder Phasenmodulzweig n Module auf. Die Anzahl der mittels ihrer galvanischen Stromanschlüsse elektrisch in Reihe geschalteten Module kann sehr verschieden sein, mindestens sind zwei Module in Reihe geschaltet, es können aber auch beispielsweise 3, 50, 100 oder mehr Module elektrisch in Reihe geschaltet sein.

Von einer (nicht dargestellten) Steuereinrichtung des Stromrichters 1 werden optische Nachrichten bzw. optische Signale über eine optische Kommunikationsverbindung (zum Beispiel über einen Lichtwellenleiter) zu den einzelnen Modulen übertragen. Beispielsweise sendet die Steuereinrichtung an die einzelnen Module jeweils einen Sollwert zur Höhe der Ausgangsspannung, die das jeweilige Modul bereitstellen soll.

In Figur 2 ist ein Ausführungsbeispiel eines weiteren modularen Multilevelstromrichters 201 dargestellt. Dieser modulare Multilevelstromrichter 201 weist neben den drei Wechselstromanschlüssen 4, 6 und 8 lediglich die drei Phasenmodulzweige 12, 22 und 28 auf. Die drei Phasenmodulzweige 12, 22 und 28 sind einer Dreieckschaltung geschaltet. Ein derartiger modularer Multilevelstromrichter kann beispielsweise zur Blindleistungskompensation eingesetzt werden. Der erste Wechselstromanschluss 4, der zweite Wechselstromanschluss 6 und der dritte Wechselstromanschluss 8 sind mit einem dreiphasigen Wechselstromnetz verbindbar.

In Figur 3 ist ein Ausführungsbeispiel eines Phasenmodulzweigs 301 dargestellt. Die in den Figuren 1 und 2 dargestellten Phasenmodulzweige können wie dieser Phasenmodulzweig 301 aufgebaut sein.

Der Phasenmodulzweig 301 weist Module 304_1, 304_2 ... 304_n auf. Diese n Module sind elektrisch in Reihe geschaltet. Mit den Modulen elektrisch in Reihe geschaltet ist eine Koppelinduktivität 307 sowie eine Strommesseinrichtung 310. Mittels der Strommesseinrichtung 310 kann festgestellt werden, ob ein Kurzschluss aufgetreten ist und deshalb ein erhöhter Strom als Kurzschlussstrom durch den Phasenmodulzweig 301 fließt.

Der Phasenmodulzweig 301 weist einen ersten Anschluss 313 sowie einen zweiten Anschluss 316 auf. Der erste Anschluss 313 ist mit der Strommesseinrichtung 310 elektrisch verbunden; der zweite Anschluss 316 ist mit der Koppelinduktivität 307 elektrisch verbunden. Der erste Anschluss 313 und der zweite Anschluss 316 können auch als ein erster Wechselstromanschluss 313 und ein zweiter Wechselstromanschluss 316 bezeichnet werden, weil mithilfe der Module 304_1 bis 304_n zwischen diesen beiden Wechselspannungsanschlüssen 313, 316 eine Wechselspannung erzeugt werden kann.

In Figur 4 ist ein Ausschnitt aus dem Phasenmodulzweig 301 der Figur 3 dargestellt. Die in Figur 4 dargestellte Reihenschaltung 401 weist k Module 304_1 bis 304_k auf, wobei k kleiner als n ist. Die Reihenschaltung 401 weist genau diejenigen k Module des modularen Multilevelstromrichters auf, welche räumlich auf einer Ebene 403 eines Stromrichterturmes angeordnet sind. Ein Stromrichterturm weist in der Regel mehrere Ebenen (Etagen) auf, so dass auf einem Stromrichterturm in mehreren Ebenen eine Vielzahl von Modulen angeordnet ist.

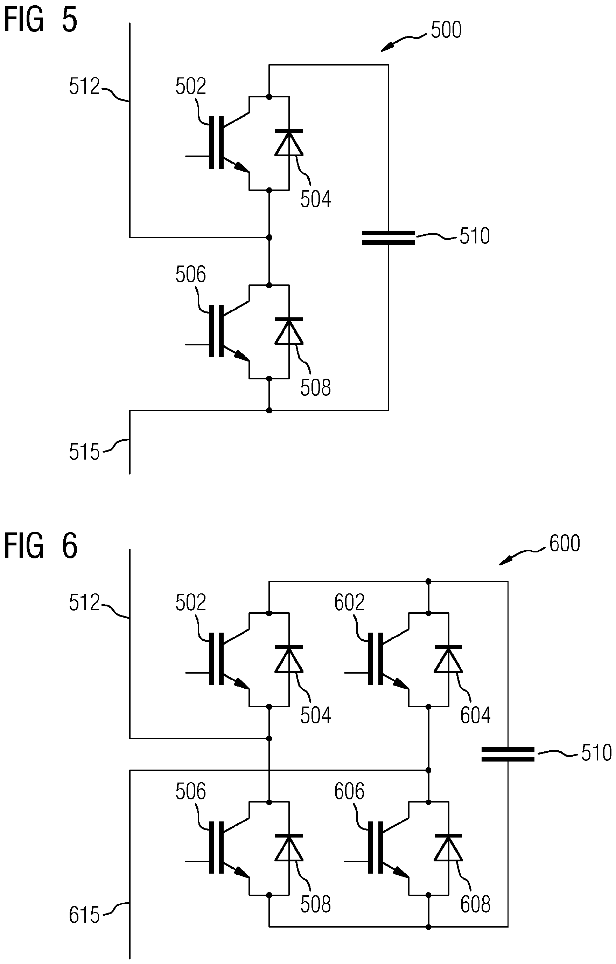

In Figur 5 ist ein Ausführungsbeispiel eines Moduls 500 des modularen Multilevelstromrichters 1 dargestellt. Dabei kann es sich beispielsweise um das Modul 304_1 des Phasenmodulzweigs 301 (oder auch um eines der anderen in Figur 3 oder 4 dargestellten Module) handeln. Das Modul ist als ein Halbbrückenmodul 500 ausgestaltet. Das Modul 500 weist ein erstes ein- und abschaltbares Leistungshalbleiterbauelement 502 mit einer ersten antiparallel geschalteten Diode 504 (erste Freilaufdiode 504) auf. Weiterhin weist das Modul 500 ein zweites ein- und abschaltbares Leistungshalbleiterbauelement 506 mit einer zweiten antiparallel geschalteten Diode 508 (zweite Freilaufdiode 508) und einen elektrischen Energiespeicher 510 in Form eines elektrischen Kondensators 510 auf. Das erste Leistungshalbleiterbauelement 502 und das zweite Leistungshalbleiterbauelement 506 sind jeweils als ein Bipolartransistor mit isolierter Gate-Elektrode ausgestaltet. Das erste Leistungshalbleiterbauelement 502 ist elektrisch in Reihe geschaltet mit dem zweiten Leistungshalbleiterbauelement 506. Am Verbindungspunkt zwischen den beiden Leistungshalbleiterbauelementen 502 und 506 ist ein erster (galvanischer) Modulanschluss 512 angeordnet. An dem Anschluss des zweiten Leistungshalbleiterbauelement 506, welcher dem Verbindungspunkt gegenüberliegt, ist ein zweiter (galvanischer) Modulanschluss 515 angeordnet. Der zweite Modulanschluss 515 ist weiterhin mit einem ersten Anschluss des Energiespeichers 510 verbunden; ein zweiter Anschluss des Energiespeichers 510 ist elektrisch verbunden mit dem Anschluss des ersten Leistungshalbleiterbauelements 502, der dem Verbindungspunkt gegenüberliegt.

Der Energiespeicher 510 ist also elektrisch parallel geschaltet zu der Reihenschaltung aus dem ersten Leistungshalbleiterbauelement 502 und dem zweiten Leistungshalbleiterbauelement 506. Durch entsprechende Ansteuerung des ersten Leistungshalbleiterbauelements 502 und des zweiten Leistungshalbleiterbauelements 506 kann erreicht werden, dass zwischen dem ersten Modulanschluss 512 und dem zweiten Modulanschluss 515 entweder die Spannung des Energiespeichers 510 ausgegeben wird oder keine Spannung ausgegeben wird (d.h. eine Nullspannung ausgegeben wird). Durch Zusammenwirken der Module der einzelnen Phasenmodulzweige kann so die jeweils gewünschte Ausgangsspannung des Stromrichters erzeugt werden.

In Figur 6 ist ein weiteres Ausführungsbeispiel eines Moduls 600 des modularen Multilevelstromrichters dargestellt. Bei diesem Modul 600 kann es sich beispielsweise um das Modul 304_n (oder auch um eines der anderen in Figur 3 oder 4 dargestellten Module) handeln. Neben den bereits aus Figur 5 bekannten ersten Leistungshalbleiterbauelement 502, zweiten Leistungshalbleiterbauelement 506, erster Freilaufdiode 504, zweiter Freilaufdiode 508 und Energiespeicher 510 weist das in Figur 6 dargestellte Modul 600 ein drittes Leistungshalbleiterbauelement 602 mit einer antiparallel geschalteten dritten Freilaufiode 604 sowie ein viertes Leistungshalbleiterbauelement 606 mit einer vierten antiparallel geschalteten Freilaufdiode 608 auf. Das dritte Leistungshalbleiterbauelement 602 und das vierte Leistungshalbleiterbauelement 606 sind jeweils als ein IGBT ausgestaltet. Im Unterschied zur Schaltung der Figur 5 ist der zweite Modulanschluss 615 nicht mit dem zweiten Leistungshalbleiterbauelement 506 elektrisch verbunden, sondern mit einem Mittelpunkt einer elektrischen Reihenschaltung aus dem dritten Leistungshalbleiterbauelement 602 und dem vierten Leistungshalbleiterbauelement 606.

Das Modul der Figur 6 ist ein sogenanntes Vollbrücken-Modul 600. Dieses Vollbrücken-Modul 600 zeichnet sich dadurch aus, dass bei entsprechender Ansteuerung der vier Leistungshalbleiterbauelemente zwischen dem ersten Modulanschluss 512 und dem zweiten Modulanschluss 615 wahlweise entweder die positive Spannung des Energiespeichers 510, die negative Spannung des Energiespeichers 510 oder eine Spannung des Wertes Null (Nullspannung) ausgegeben werden kann. Somit kann also mittels des Vollbrücken-Moduls 600 die Polarität der Ausgangsspannung umgekehrt werden. Ein modularer Multilevelstromrichter kann entweder nur Halbbrücken-Module 500, nur Vollbrücken-Module 600 oder auch Halbbrücken-Module 500 und Vollbrücken-Module 600 aufweisen.

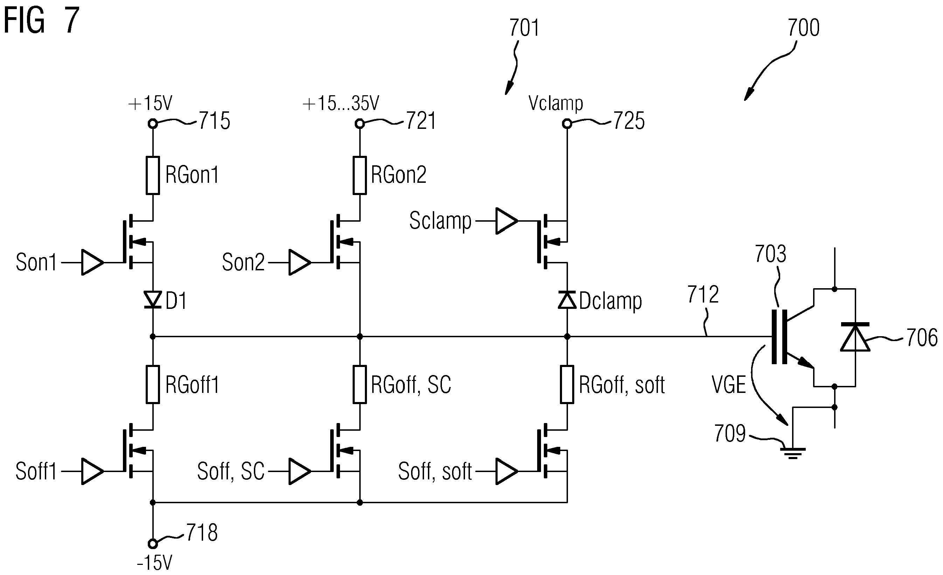

In Figur 7 ist beispielhaft eine Leistungshalbleitereinheit 700 dargestellt, welche eine Ansteuerschaltung 701 und ein mit der Ansteuerschaltung elektrisch verbundenes bipolares schaltbares Leistungshalbleiterbauelement 703 aufweist. Im Ausführungsbeispiel handelt es sich bei dem bipolaren schaltbaren Leistungshalbleiterbauelement 703 um einen Bipolartransistor 703 mit isolierter Gate-Elektrode (IGBT, Insulated Gate Bipolar Transistor). Dieser Transistor 703 weist einen Kollektoranschluss, einen Emitter-Anschluss sowie einen Gate-Anschluss auf. Der Emitter-Anschluss ist mittels einer Freilaufdiode 706 mit dem Kollektor-Anschluss verbunden, wobei die Anode der Freilaufdiode 706 mit dem Emitter-Anschluss und die Kathode der Freilaufdiode 706 mit dem Kollektor-Anschluss elektrisch verbunden ist. Der Emitter-Anschluss ist mit Erdpotential 709 verbunden. Der Gate-Anschluss des Leistungshalbleiterbauelements 703 ist mit einem Ausgang 712 der Ansteuerschaltung 701 verbunden. An diesem Ausgang 712 der Ansteuerschaltung 701 können (beim Ausführungsbeispiel) Spannungen zwischen -15 V und + 35 V ausgegeben werden. Somit kann das bipolare schaltbare Leistungshalbleiterbauelement 703 mit nahezu beliebigen Gate-Emitter-Spannungsverläufen zwischen -15 V und +35 V beaufschlagt werden.

Über einen ersten Anschluss 715 wird die Ansteuerschaltung 701 mit einer positiven Spannung (im Ausführungsbeispiel +15 V) versorgt; über einen zweiten Anschluss 718 wird die Ansteuerschaltung 701 mit einer negativen Spannung (im Ausführungsbeispiel -15V) versorgt. Über einen dritten Anschluss 721 wird die Ansteuerschaltung 701 mit einer variablen Spannung (variable Versorgungsspannung, im Ausführungsbeispiel variabel zwischen +15V und +35V) versorgt. Über einen vierten Anschluss 725 wird die Ansteuerschaltung 701 optional mit einer weiteren Spannung versorgt, welche im Ausführungsbeispiel als Clamp-Spannung (Vclamp)bezeichnet wird. Diese Clamp-Spannung wird beim Einschalten des Leistungshalbleiterbauelements 703 nicht benötigt; sie wird vielmehr nur beim Ausschalten des Leistungshalbleiterbauelements 703 benötigt. Der erste Anschluss 715, der zweite Anschluss 718 und der dritte Anschluss 721 sind jeweils schaltbar über einen ohmschen Widerstand RGon1, RGon2, RGoff1, RGoff, SC bzw. RGoff, soft mit dem Ausgang 712 der Ansteuerschaltung verbunden. Dabei kann jeder der Anschlüsse mittels mindestens eines elektronischen Schalters Son1, Son2, Soffi, Soff, SC bzw. Soff, soft mit dem Ausgang 712 verbunden oder von dem Ausgang 712 getrennt werden. Die elektronischen Schalter weisen jeweils einen Feldeffekttransistor auf. Zusätzlich sind Dioden D1 und Dclamp vorhanden, welche einen Stromfluss jeweils nur in einer Richtung zulassen. Beim Einschalten des Leistungshalbleiterbauelements werden lediglich die drei Zweige mit den elektronischen Schaltern Son1, Son2 und Soff1 benötigt, die drei Zweige mit den elektronischen Schaltern Soff,SC, Soff,soft und Sclamp werden beim Ausschaltvorgang des Leistungshalbleiterbauelements benötigt.

Weiter unten ist dargestellt, wie durch Öffnen und Schließen der Schalter Son1, Son2 und Soff1 am Ausgang 712 der Ansteuerschaltung die gewünschte Gate-Spannung für das bipolare schaltbare Leistungshalbleiterbauelement 703 erzeugt und somit die gewünschte Gate-Emitter-Spannung für das Leistungshalbleiterbauelement 703 bereitgestellt werden kann.

Die Ansteuerschaltung 701 weist also einen Gate-Treiber mit einer mehrstufigen Endstufe auf. Durch diese Ansteuerschaltung wird der Gate-Anschluss des Leistungshalbleiterbauelements mit unterschiedlichen Spannungsniveaus verbunden. Das Ein- und Ausschalten der einzelnen Schalter Son1, Son2 und Soff1 kann zeitgesteuert oder eventgesteuert erfolgen. Selbstverständlich sind auch andere Ausführungen denkbar, um den gewünschten Verlauf der Gate-Emitter-Spannung zu erzeugen. Beispielsweise kann die an dem Gate-Anschluss anliegende Gate-Spannung mittels einer Pulsweitenmodulation oder einer programmierbaren Spannungsquelle erzeugt werden. Denkbar ist weiterhin die Erzeugung eines derartigen Gate-Emitter-Spannungsverlaufes durch Ladung oder Entladung von RC-Gliedern. Die Module 500 und 600 des modularen Multilevelstromrichters können Ansteuerschaltungen 701 aufweisen, die jeweils den Leistungshalbleiterbauelementen der Module zugeordnet sind. Die Module können also Leistungshalbleitereinheiten 700 aufweisen.

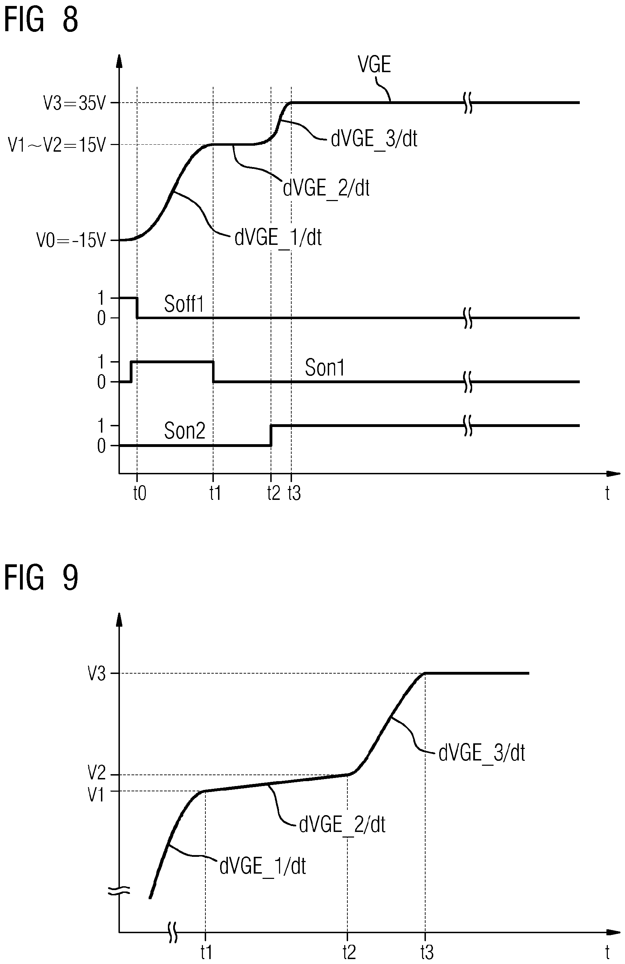

In Figur 8 ist ein beispielhafter Ablauf des Verfahrens zum Einschalten des bipolaren schaltbaren Leistungshalbleiterbauelements 703 dargestellt. Dabei ist im oberen Teil des Diagramms der zeitliche Verlauf der Gate-Emitter-Spannung VGE dargestellt, während im unteren Teil des Diagramms der zeitliche Verlauf des Ein- bzw. Ausschaltens der elektronischen Schalter Son1, Son2 und Soff1 mittels Logiksignalen dargestellt ist. Das Ein- und Ausschalten dieser elektronischen Schalter führt in Verbindung mit den an die Ansteuerschaltung angelegten Versorgungsspannungen zu dem dargestellten Verlauf der Gate-Emitter Spannung VGE.

Im Ausgangszustand (t=0) weist die Gate-Emitter-Spannung VGE einen negativen maximalen Spannungswert V0 auf (im Ausführungsbeispiel ist V0=-15 V). Der Schalter Soff1 ist eingeschaltet, die Schalter Son1 und Son2 sind ausgeschaltet. Die übrigen Schalter Soff,SC, Soff,soft und Sclamp sind ebenfalls ausgeschaltet und werden im Folgenden nicht berücksichtigt.

Daraufhin wird der Schalter Son1 eingeschaltet und zum Zeitpunkt t = t0 wird der Schalter Soff1 ausgeschaltet. Daraufhin steigt die Gate-Emitter-Spannung von -15V ausgehend in einem ersten Zeitabschnitt (t0-t1) mit einer ersten Spannungsänderungsgeschwindigkeit dVGE_1/dt) bis zu einem ersten Spannungswert V1 an (V1 beträgt im Ausführungsbeispiel +15V). Zum Zeitpunkt t = t1 wird der Schalter Son1 ausgeschaltet. Daraufhin bleibt die Gate-Emitter-Spannung in einem zweiten Zeitabschnitt zwischen t1 und t2 konstant. In diesem zweiten Zeitabschnitt zwischen t1 und t2 ist also die mittlere Spannungsänderungsgeschwindigkeit dVGE_2/dt = 0. Zum Zeitpunkt t = t2 wird der Schalter Son2 eingeschaltet. Daraufhin steigt die Gate-Emitter-Spannung in einem dritten Zeitabschnitt zwischen t2 und t3 mit einer dritten Spannungsänderungsgeschwindigkeit dVGE_3/dt bis zu einem dritten Spannungswert V3 an. Je nach Wahl der an dem dritten Anschluss 721 der Ansteuerschaltung angelegten Versorgungsspannung kann der dritte Spannungswert zwischen +15V und +35V betragen. Vorzugsweise wird der dritte Spannungswert V3 >= 18 V eingestellt, also im Ausführungsbeispiel im Bereich zwischen +18V und +35V.

Die Gate-Emitter-Spannung steigt auf den dritten Spannungswert V3 an und bleibt daraufhin konstant. Das Leistungshalbleiterbauelement ist eingeschaltet; aufgrund der erhöhten Gate-Emitter-Spannung VGE treten im eingeschalteten Zustand nur geringe Durchlassverluste des Leistungshalbleiterbauelements auf. Im Ausführungsbeispiel der Figur 8 ist gut zu erkennen, dass die zweite Spannungsänderungsgeschwindigkeit dVGE_2/dt kleiner ist als die erste Spannungsänderungsgeschwindigkeit dVGE_1/dt. Die zweite Spannungsänderungsgeschwindigkeit dVGE_2/dt ist auch kleiner als die dritte Spannungsänderungsgeschwindigkeit dVGE_3/dt. Dadurch wird erreicht, dass der zweite Zeitabschnitt zwischen t1 und t2 einen Warte-Zeitabschnitt darstellt. In diesem zweiten Zeitabschnitt kann auf als solche bekannte Art und Weise der durch das Leistungshalbleiterbauelement 703 fließende Strom gemessen und festgestellt werden, ob dieser Strom unzulässig groß ist. Sollte dieser Strom unzulässig groß sein, so weist dies darauf hin, dass ein Typ-1-Kurzschluss vorliegt, das heißt, dass das Leistungshalbleiterbauelement 703 bei einem bereits existierenden Kurzschluss eingeschaltet wird. Daraufhin wird das weitere Erhöhen der Gate-Emitter-Spannung abgebrochen, so dass der durch das Leistungshalbleiterbauelement fließende Strom begrenzt wird und eine Zerstörung des Leistungshalbleiterbauelements vermieden wird. Wenn jedoch während des zweiten Zeitabschnitts (t1-t2) kein unzulässig großer Strom durch das Leistungshalbleiterbauelement 703 festgestellt wird, so wird erkannt, dass kein Typ-1-Kurzschluss vorliegt und die Gate-Emitter-Spannung wird in dem dritten Zeitabschnitt auf den Maximalwert V3 erhöht. In Figur 8 ist beispielhaft ein Fall dargestellt, bei dem im zweiten Zeitabschnitt die Gate-Emitter-Spannung konstant bleibt, die zweite mittlere Spannungsänderungsgeschwindigkeit also Null ist.

In Figur 9 ist ein Beispiel für einen zweiten Zeitabschnitt dargestellt, bei dem die Gate-Emitter-Spannung während des zweiten Zeitabschnitts mit einer geringen zweiten Spannungsänderungsgeschwindigkeit dVGE_2/dt vergrößert wird (die zweite mittlere Spannungsänderungsgeschwindigkeit dVGE_2/dt ist also ungleich Null) . Dies kann bei der Ansteuerschaltung gemäß Figur 7 beispielsweise dadurch erreicht werden, dass die an den dritten Anschluss 721 angelegte Versorgungsspannung während des zweiten Zeitabschnitts langsam linear vergrößert wird. Zum Zeitpunkt t = t1 hat die Gate-Emitter-Spannung VGE den ersten Spannungswert V1 = 15V. Danach vergrößert sich die Gate-Emitter-Spannung linear, bis sie zum Zeitpunkt t = t2 den zweiten Spannungswert V2 erreicht. Dieser zweite Spannungswert V2 kann im Ausführungsbeispiel leicht oberhalb des ersten Spannungswertes V1 liegen, beispielsweise bei V2 = 16V. Obwohl die Gate-Emitter-Spannung im zweiten Zeitabschnitt geringfügig ansteigt, stellt der zweite Zeitabschnitt auch hier einen Warte-Zeitabschnitt dar. Während des zweiten Zeitabschnitts kann die Kurzschlusserkennung durchgeführt werden. Ansonsten verläuft der in Figur 9 dargestellte Verlauf der Gate-Emitter-Spannung gleichartig wie der in Figur 8 dargestellte Verlauf.

Weiterhin ist in Figur 9 deutlich zu erkennen, dass die zweite mittlere Spannungsänderungsgeschwindigkeit dVGE_2/dt mindestens um den Faktor 5 kleiner ist als die erste mittlere Spannungsänderungsgeschwindigkeit dVGE_1/dt und als die dritte mittlere Spannungsänderungsgeschwindigkeit dVGE_3/dt. Dabei kann die zweite mittlere Spannungsänderungsgeschwindigkeit dVGE_2/dt zwischen 0 und 1V pro us liegen, insbesondere zwischen 0,01 und 1V pro µs. Der zweite Zeitabschnitt kann beispielsweise zwischen 2 und 100 us lang sein, insbesondere zwischen 10 und 100 us. Der zweite Zeitabschnitt kann aber auch andere Längen annehmen, beispielsweise zwischen 2 und 50 us. Der dritte Spannungswert beträgt vorzugsweise zwischen 18 und 35V.

Vorzugsweise wird während des zweiten Zeitabschnitts die Gate-Emitter-Spannung zwischen 0 und 5 V, insbesondere zwischen 0 und 3V, erhöht. Mit anderen Worten gesagt, beträgt das Produkt aus der zweiten mittleren Spannungsänderungsgeschwindigkeit und der Länge des zweiten Zeitabschnitts zwischen 0 und 5 V, insbesondere zwischen 0 und 3 V.

Es wurde ein Verfahren und eine Ansteuerschaltung beschrieben, mit denen (insbesondere bei einem modularen Multilevelstromrichter) bipolare schaltbare Leistungshalbleiterbauelements im stationären Zustand mit einer erhöhten Gate-Emitter-Spannung betrieben werden können. Die Gate-Emitter-Spannung kann insbesondere größer als 18V sein. Vorliegende Kurzschlüsse (zum Beispiel insbesondere Kurzschlüsse aufgrund von stromrichterinternen Fehlern in den Modulen des modularen Multilevelstromrichters) können dabei sicher erkannt werden, und es kann sichergestellt werden, dass die auftretenden Kurzschlussströme keine zu hohen Werte annehmen. Somit kann eine Zerstörung des bipolaren schaltbaren Leistungshalbleiterbauelements vermieden werden.

Wenn ein modularer Multilevelstromrichter einen internen Fehler aufweist, kann es passieren, dass während der Fehlererkennung und Fehlerklärung einige Module des Stromrichters eingeschaltet werden obwohl bereits ein Kurzschluss existiert. Beispielsweise können zwischen vier und acht Module einen derartigen Kurzschluss aufweisen. Insbesondere während des Einschaltens des bipolaren schaltbaren Leistungshalbleiterbauelements muss der maximale Strom begrenzt werden, damit keine thermische Zerstörung/ latch-up des Leistungshalbleiterbauelements erfolgt. Das beschriebene Verfahren und die beschriebene Ansteuerschaltung ermöglichen eine derartige Begrenzung des maximalen Kurzschlussstroms.

Verfahren zur schnellen Erkennung eines Kurzschlusses als solche sind bekannt und werden hier nicht näher beschrieben. Diese bekannten Verfahren können beispielsweise auf einer Messung des durch das Leistungshalbleiterbauelement fließenden Stroms oder auf einer Schätzung dieses Stroms basieren. Das Verfahren und die Ansteuerschaltung funktionieren prinzipiell mit den verschiedensten bekannten Kurzschlusserkennungsmethoden, wobei sich diese in der Schnelligkeit der Erkennung des Kurzschlusses unterscheiden. Bei den bisher gebräuchlichen Gate-Emitter-Spannungen von maximal 15V bleibt auch bei Auftreten eines Typ 1-Kurzschlusses ausreichend Zeit, um das Leistungshalbleiterbauelement mittels klassischer Entsättigungsmethoden abzuschalten. In dem Fall einer erhöhten Gate-Emitter-Spannung größer als 18V wird jedoch die Entsättigung des Leistungshalbleiterbauelements sehr langsam sein, und der Kurzschlussstrom kann extrem hohe Werte erreichen. Dadurch kann das Leistungshalbleiterbauelement geschädigt werden, beispielsweise durch Bildung von sogenannten hot-spots oder latch-up-Effekten.

Bei dem Verfahren und der Ansteuerschaltung findet eine Erhöhung der Gate-Emitter-Spannung über 15V hinaus statt, wobei eine langsam steigende Flanke der Gate-Emitter-Spannung (oder eine Wartezeit bei konstanter Gate-Emitter-Spannung) ab dem Moment der Stromübernahme durch das Leistungshalbleiterbauelement während des Einschaltens stattfindet. Beim Einschalten des Leistungshalbleiterbauelements treten insbesondere drei aufeinander folgende ansteigende Verläufe der Gate-Emitter-Spannung (drei Rampen) auf. Direkt nach dem Beginn des Einschaltens wird die Gate-Emitter-Spannung des Leistungshalbleiterbauelements mit einer sehr großen Spannungsänderungsgeschwindigkeit bis zu dem ersten Spannungswert V1 erhöht. Dieser erste Spannungswert kann beispielsweise 15V betragen. Der erste Spannungswert kann auch die Spannung sein, bei der der Kollektorstrom nicht weiter ansteigt. Der erste Zeitabschnitt kann eventgesteuert oder zeitgesteuert beendet werden. Daraufhin wird die Gate-Emitter-Spannung mit einer sehr geringen Spannungsänderungsgeschwindigkeit bis zum zweiten Spannungswert V2 erhöht. Dieser zweite Spannungswert V2 ist kleiner als der dritte (maximale) Spannungswert V3. Nach dem Ende des zweiten Zeitabschnitts steigt dann die Gate-Emitter-Spannung mit einer sehr hohen vorgegebenen Spannungsänderungsgeschwindigkeit auf den dritten Spannungswert V3. Der zweite Zeitabschnitt kann zeitgesteuert oder eventgesteuert beendet werden.

Dieses Verfahren ermöglicht das Einschalten des Leistungshalbleiterbauelements mit einer zunächst vergleichsweise kleinen Gate-Emitter-Spannung (erster Spannungswert V1, beispielsweise 15V), was zu einer starken Begrenzung des Kurzschlussstroms bei einem Kurzschluss des Typs 1 führt. Durch das Einschalten des Leistungshalbleiterbauelements bei dem ersten Spannungswert wird erreicht, dass sich die Kurzschluss-1-Eigenschaften des Leistungshalbleiterbauelements zunächst (gegenüber einem Betrieb mit der vergleichsweise kleinen Gate-Emitter-Spannung, erster Spannungswert V1) nicht verändern. Daher kann die Kurzschlusserkennung und die gegebenenfalls darauf folgende Leistungshalbleiterbauelement-Abschaltung mittels der herkömmlichen Verfahren durchgeführt werden. Erst wenn während des zweiten Zeitabschnitts das Vorliegen eines Kurzschlusses sicher ausgeschlossen werden kann, wird die Gate-Emitter-Spannung auf den dritten Spannungswert V3 erhöht, welcher größer oder gleich 18V ist. Dann wird das Leistungshalbleiterbauelement stationär mit der erhöhten Gate-Emitter-Spannung betrieben, wodurch sich die beschriebenen vorteilhaften Eigenschaften beim eingeschalteten Zustand des Leistungshalbleiterbauelements ergeben.

## Patentansprüche

1. Verfahren zum Einschalten eines bipolaren schaltbaren Leistungshalbleiterbauelements (703), bei dem
- in einem ersten Zeitabschnitt (t0-t1) die Gate-Emitter-Spannung (VGE) des Leistungshalbleiterbauelements (703) mit einer ersten mittleren Spannungsänderungsgeschwindigkeit (dVGE_1/dt) bis zu einem ersten Spannungswert (V1) erhöht wird,
- danach in einem zweiten Zeitabschnitt (t1-t2) die Gate-Emitter-Spannung (VGE) konstant gehalten oder bis zu einem zweiten Spannungswert (V2) erhöht wird, wobei die Gate-Emitter-Spannung in dem zweiten Zeitabschnitt eine zweite mittlere Spannungsänderungsgeschwindigkeit (dVGE _2/dt) aufweist, die kleiner ist als die erste mittlere Spannungsänderungsgeschwindigkeit (dVGE_1/dt), und
- danach in einem dritten Zeitabschnitt (t2-t3) die Gate-Emitter-Spannung mit einer dritten mittleren Spannungsänderungsgeschwindigkeit (dVGE_3/dt) bis zu einem dritten Spannungswert (V3) erhöht wird, wobei die dritte mittlere Spannungsänderungsgeschwindigkeit (dVGE _3/dt) größer ist als die zweite mittlere Spannungsänderungsgeschwindigkeit (dVGE_2/dt) und der dritte Spannungswert (V3) größer als oder gleich 18V ist,
**dadurch gekennzeichnet, dass**
- während des zweiten Zeitabschnitts festgestellt wird, ob durch das Leistungshalbleiterbauelement ein unzulässig großer Strom fließt und nur dann zu dem dritten Zeitabschnitt übergegangen wird, wenn kein unzulässig großer Strom festgestellt worden ist.

2. Verfahren nach Anspruch 1,
**dadurch gekennzeichnet, dass**
- die zweite mittlere Spannungsänderungsgeschwindigkeit (dVGE _2/dt) mindestens um den Faktor 5 kleiner ist als die erste mittlere Spannungsänderungsgeschwindigkeit (dVGE_1/dt).

3. Verfahren nach Anspruch 1 oder 2,
**dadurch gekennzeichnet, dass**
- die zweite mittlere Spannungsänderungsgeschwindigkeit (dVGE_2/dt) mindestens um den Faktor 5 kleiner ist als die dritte mittlere Spannungsänderungsgeschwindigkeit (dVGE _3/dt).

4. Verfahren nach einem der vorhergehenden Ansprüche,
**dadurch gekennzeichnet, dass**
- die zweite mittlere Spannungsänderungsgeschwindigkeit (dVGE_2/dt) zwischen 0 und 1 V/µs liegt.

5. Verfahren nach einem der vorhergehenden Ansprüche,
**dadurch gekennzeichnet, dass**
- der zweite Zeitabschnitt (t1-t2) zwischen 2 und 100 µs lang ist.

6. Verfahren nach einem der vorhergehenden Ansprüche,
**dadurch gekennzeichnet, dass**
- der dritte Spannungswert (V3) der Gate-Emitter-Spannung des Leistungshalbleiterbauelements (703) im eingeschalteten Zustand entspricht.

7. Verfahren nach einem der vorhergehenden Ansprüche,
**dadurch gekennzeichnet, dass**
- der dritte Spannungswert (V3) zwischen 18 und 35 V beträgt.

8. Verfahren nach einem der vorhergehenden Ansprüche,
**dadurch gekennzeichnet, dass**
- das Verfahren ein Verfahren zum Einschalten eines Leistungshalbleiterbauelements (502) eines Moduls (500) eines modularen Multilevelstromrichters (1) ist, wobei der modulare Multilevelstromrichter eine Vielzahl von Modulen (500) aufweist, die eine elektrische Reihenschaltung bilden, die Module (500) jeweils mindestens das Leistungshalbleiterbauelement (502), ein zweites Leistungshalbleiterbauelement (506) und einen elektrischen Energiespeicher (510) aufweisen, wobei das Leistungshalbleiterbauelement (502) und das zweite Leistungshalbleiterbauelement (506) in einer Halbbrückenschaltung angeordnet sind, oder die Module (600) jeweils mindestens das Leistungshalbleiterbauelement (502), ein zweites Leistungshalbleiterbauelement (506) , ein drittes Leistungshalbleiterbauelement (602), ein viertes Leistungshalbleiterbauelement (606) und einen elektrischen Energiespeicher (510) aufweisen, wobei das Leistungshalbleiterbauelement (502), das zweite Leistungshalbleiterbauelement (504), das dritte Leistungshalbleiterbauelement (602) und das vierte Leistungshalbleiterbauelement (606) in einer Vollbrückenschaltung angeordnet sind.

9. Verfahren nach einem der vorhergehenden Ansprüche,
**dadurch gekennzeichnet, dass**
- die Gate-Emitter-Spannung ausgehend von einem negativen Spannungswert (V0) bis zu dem dritten Spannungswert (V3) erhöht wird, wobei der Betrag des dritten Spannungswerts (V3) größer ist als der Betrag des negativen Spannungswerts (V0).

10. Verfahren nach einem der vorhergehenden Ansprüche,
**dadurch gekennzeichnet, dass**
- das bipolare schaltbare Leistungshalbleiterbauelement ein Bipolartransistor mit isolierter Gate-Elektrode (703) ist.

11. Ansteuerschaltung (701) für ein bipolares schaltbares Leistungshalbleiterbauelement (703), die zum Ausgeben einer Gate-Emitter-Spannung für das Leistungshalbleiterbauelement (703) eingerichtet ist, wobei
- die Gate-Emitter-Spannung (VGE) in einem ersten Zeitabschnitt (t0-t1) mit einer ersten mittleren Spannungsänderungsgeschwindigkeit (dVGE_1/dt) bis zu einem ersten Spannungswert (V1) ansteigt,
- danach die Gate-Emitter-Spannung in einem zweiten Zeitabschnitt (t1-t2) konstant bleibt oder bis zu einem zweiten Spannungswert (V2) ansteigt, wobei die Gate-Emitter-Spannung in dem zweiten Zeitabschnitt eine zweite mittlere Spannungsänderungsgeschwindigkeit (dVGE_2/dt) aufweist, die kleiner ist als die erste mittlere Spannungsänderungsgeschwindigkeit (dVGE_1/dt), und
- danach die Gate-Emitter-Spannung in einem dritten Zeitabschnitt (t2-t3) mit einer dritten mittleren Spannungsänderungsgeschwindigkeit (dVGE _3/dt) bis zu einem dritten Spannungswert (V3) ansteigt, wobei die dritte mittlere Spannungsänderungsgeschwindigkeit (dVGE _3/dt) größer ist als die zweite mittlere Spannungsänderungsgeschwindigkeit (dVGE_2/dt) und der dritte Spannungswert (V3) größer als oder gleich 18V ist, **dadurch gekennzeichnet, dass**
- während des zweiten Zeitabschnitts festgestellt wird, ob durch das Leistungshalbleiterbauelement ein unzulässig großer Strom fließt und die Ansteuerschaltung nur dann zu dem dritten Zeitabschnitt übergeht, wenn kein unzulässig großer Strom festgestellt worden ist.

12. Ansteuerschaltung nach Anspruch 11,
**dadurch gekennzeichnet, dass**
- die zweite mittlere Spannungsänderungsgeschwindigkeit (dVGE _2/dt) mindestens um den Faktor 5 kleiner ist als die erste mittlere Spannungsänderungsgeschwindigkeit (dVGE_1/dt).

13. Ansteuerschaltung nach Anspruch 11 oder 12,
**dadurch gekennzeichnet, dass**
- die zweite mittlere Spannungsänderungsgeschwindigkeit (dVGE _2/dt) mindestens um den Faktor 5 kleiner ist als die dritte mittlere Spannungsänderungsgeschwindigkeit (dVGE_3/dt).

14. Ansteuerschaltung nach einem der Ansprüche 11 bis 13,
**dadurch gekennzeichnet, dass**
- die zweite mittlere Spannungsänderungsgeschwindigkeit (dVGE_2/dt) zwischen 0 und 1 V/µs liegt.

15. Ansteuerschaltung nach einem der Ansprüche 11 bis 14,
**dadurch gekennzeichnet, dass**
- der zweite Zeitabschnitt (t1-t2) zwischen 2 und 100 µs lang ist.

16. Ansteuerschaltung nach einem der Ansprüche 11 bis 15,
**dadurch gekennzeichnet, dass**
- der dritte Spannungswert (V3) der Gate-Emitter-Spannung des Leistungshalbleiterbauelements (703) im eingeschalteten Zustand entspricht.

17. Ansteuerschaltung nach einem der Ansprüche 11 bis 16,
**dadurch gekennzeichnet, dass**
- der dritte Spannungswert (V3) zwischen 18 und 35 V beträgt.

18. Ansteuerschaltung nach einem der Ansprüche 11 bis 17,
**dadurch gekennzeichnet, dass**
- die Gate-Emitter-Spannung ausgehend von einem negativen Spannungswert (V0) bis zu dem dritten Spannungswert (V3) ansteigt, wobei der Betrag des dritten Spannungswerts (V3) größer ist als der Betrag des negativen Spannungswerts (V0).

19. Ansteuerschaltung nach einem der Ansprüche 11 bis 18,
**dadurch gekennzeichnet, dass**
- das bipolare schaltbare Leistungshalbleiterbauelement ein Bipolartransistor (703) mit isolierter Gate-Elektrode ist.

20. Leistungshalbleitereinheit (700) mit einem bipolaren schaltbaren Leistungshalbleiterbauelement (703), insbesondere mit einem Bipolartransistor mit isolierter Gate-Elektrode, und mit einer Ansteuerschaltung (701) nach einem der Ansprüche 11 bis 19.

21. Modul (500, 600) eines modularen Multilevelstromrichters (1) mit einer Leistungshalbleitereinheit (700) nach Anspruch 20.

## Claims

1. Method for switching on a bipolar switchable power semiconductor component (703), wherein
- in a first time segment (t0-t1) the gate-emitter voltage (VGE) of the power semiconductor component (703) is increased to a first voltage value (V1) at a first average voltage change rate (dVGE_1/dt),
- afterwards in a second time segment (t1-t2) the gate-emitter voltage (VGE) is kept constant or is increased to a second voltage value (V2), in the second time segment the gate-emitter voltage having a second average voltage change rate (dVGE 2/dt), which is less than the first average voltage change rate (dVGE_1/dt), and
- afterwards in a third time segment (t2-t3) the gate-emitter voltage is increased to a third voltage value (V3) at a third average voltage change rate (dVGE_3/dt), the third average voltage change rate (dVGE 3/dt) being greater than the second average voltage change rate (dVGE_2/dt) and the third voltage value (V3) being greater than or equal to 18 V,
**characterized in that**
- during the second time segment it is ascertained whether an impermissibly high current is flowing through the power semiconductor component, and a transition is made to the third time segment only if no impermissibly high current has been ascertained.

2. Method according to Claim 1,
**characterized in that**
- the second average voltage change rate (dVGE_2/dt) is less than the first average voltage change rate (dVGE_1/dt) at least by the factor of 5.

3. Method according to Claim 1 or 2,
**characterized in that**
- the second average voltage change rate (dVGE_2/dt) is less than the third average voltage change rate (dVGE_3/dt) at least by the factor of 5.

4. Method according to any of the preceding claims,
**characterized in that**
- the second average voltage change rate (dVGE_2/dt) is between 0 and 1 V/µs.

5. Method according to any of the preceding claims,
**characterized in that**
- the second time segment (t1-t2) has a length of between 2 and 100 µs.

6. Method according to any of the preceding claims,
**characterized in that**
- the third voltage value (V3) corresponds to the gate-emitter voltage of the power semiconductor component (703) in the switched-on state.

7. Method according to any of the preceding claims,
**characterized in that**
- the third voltage value (V3) is between 18 and 35 V.

8. Method according to any of the preceding claims,
**characterized in that**
- the method is a method for switching on a power semiconductor component (502) of a module (500) of a modular multilevel power converter (1), the modular multilevel power converter comprising a multiplicity of modules (500) forming an electrical series circuit, the modules (500) each comprising at least the power semiconductor component (502), a second power semiconductor component (506) and an electrical energy store (510), the power semiconductor component (502) and the second power semiconductor component (506) being arranged in a half-bridge circuit, or the modules (600) each comprising at least the power semiconductor component (502), a second power semiconductor component (506), a third power semiconductor component (602), a fourth power semiconductor component (606) and an electrical energy store (510), the power semiconductor component (502), the second power semiconductor component (504), the third power semiconductor component (602) and the fourth power semiconductor component (606) being arranged in a full-bridge circuit.

9. Method according to any of the preceding claims,
**characterized in that**
- the gate-emitter voltage is increased to the third voltage value (V3) proceeding from a negative voltage value (V0), the magnitude of the third voltage value (V3) being greater than the magnitude of the negative voltage value (V0).

10. Method according to any of the preceding claims,
**characterized in that**
- the bipolar switchable power semiconductor component is an insulated gate bipolar transistor (703).

11. Control circuit (701) for a bipolar switchable power semiconductor component (703), said control circuit being configured for outputting a gate-emitter voltage for the power semiconductor component (703), wherein
- in a first time segment (t0-t1) the gate-emitter voltage (VGE) is increased to a first voltage value (V1) at a first average voltage change rate (dVGE_1/dt),
- afterwards in a second time segment (t1-t2) the gate-emitter voltage is kept constant or is increased to a second voltage value (V2), in the second time segment the gate-emitter voltage having a second average voltage change rate (dVGE 2/dt), which is less than the first average voltage change rate (dVGE_1/dt), and
- afterwards in a third time segment (t2-t3) the gate-emitter voltage is increased to a third voltage value (V3) at a third average voltage change rate (dVGE_3/dt), the third average voltage change rate (dVGE 3/dt) being greater than the second average voltage change rate (dVGE_2/dt) and the third voltage value (V3) being greater than or equal to 18 V,
**characterized in that**
- during the second time segment it is ascertained whether an impermissibly high current is flowing through the power semiconductor component, and the control circuit makes the transition to the third time segment only if no impermissibly high current has been ascertained.

12. Control circuit according to Claim 11,
**characterized in that**
- the second average voltage change rate (dVGE_2/dt) is less than the first average voltage change rate (dVGE_1/dt) at least by the factor of 5.

13. Control circuit according to Claim 11 or 12,
**characterized in that**
- the second average voltage change rate (dVGE_2/dt) is less than the third average voltage change rate (dVGE_3/dt) at least by the factor of 5.

14. Control circuit according to any of Claims 11 to 13,
**characterized in that**
- the second average voltage change rate (dVGE_2/dt) is between 0 and 1 V/µs.

15. Control circuit according to any of Claims 11 to 14,
**characterized in that**
- the second time segment (t1-t2) has a length of between 2 and 100 µs.

16. Control circuit according to any of Claims 11 to 15,
**characterized in that**
- the third voltage value (V3) corresponds to the gate-emitter voltage of the power semiconductor component (703) in the switched-on state.

17. Control circuit according to any of Claims 11 to 16,
**characterized in that**
- the third voltage value (V3) is between 18 and 35 V.

18. Control circuit according to any of Claims 11 to 17,
**characterized in that**
- the gate-emitter voltage is increased to the third voltage value (V3) proceeding from a negative voltage value (V0), the magnitude of the third voltage value (V3) being greater than the magnitude of the negative voltage value (V0).

19. Control circuit according to any of Claims 11 to 18,
**characterized in that**
- the bipolar switchable power semiconductor component is an insulated gate bipolar transistor (703).

20. Power semiconductor unit (700) comprising a bipolar switchable power semiconductor component (703), in particular comprising an insulated gate bipolar transistor, and comprising a control circuit (701) according to any of Claims 11 to 19.

21. Module (500, 600) of a modular multilevel power converter (1) comprising a power semiconductor unit (700) according to Claim 20.

## Revendications

1. Procédé de mise à l'état passant d'un élément (703) à semiconducteur de puissance bipolaire commutable, dans lequel
- dans un premier laps de temps (t0-t1), on élève, jusqu'à une première valeur (V1) de tension, la tension (VGE) grille - émetteur du composant (703) à semiconducteur de puissance à une première vitesse (dVGE_1/dt) moyenne de variation de la tension,
- ensuite, dans un deuxième laps de temps (t1-t2), on maintient constante la tension (VGE) de grille - émetteur ou on l'élève jusqu'à une deuxième valeur (V2) de tension, dans lequel la tension grille - émetteur a, dans le deuxième laps de temps, une deuxième vitesse (dVGE_2/dt) moyenne de variation de la tension, qui est plus petite que la première vitesse (dVGE_1/dt) moyenne de variation de la tension, et
- ensuite, dans un troisième laps de temps (t2-t3), on élève, jusqu'à une troisième valeur (V3) de tension, la tension grille - émetteur à une troisième vitesse (dVGE_3/dt) moyenne de variation de la tension, dans lequel la troisième vitesse (dVGE_3/dt) moyenne de variation de la tension est plus grande que la deuxième vitesse (dVGE_2/dt) moyenne de variation de la tension et la troisième valeur (V3) de la tension est supérieure ou égale à 18V, **caractérisé en ce que**
- pendant le deuxième laps de temps, on constate s'il passe, dans l'élément à semiconducteur de puissance, un courant d'une grande intensité inadmissible et l'on ne passe au troisième laps de temps que s'il n'a pas été constaté un courant d'une grande intensité inadmissible.

2. Procédé suivant la revendication 1,
**caractérisé en ce que**
- la deuxième vitesse (dVGE_2/dt) moyenne de variation de la tension est plus petite au moins du facteur 5 que la première vitesse (dVGE_1/dt) moyenne de variation de la tension.

3. Procédé suivant la revendication 1 ou 2,
**caractérisé en ce que**
- la deuxième vitesse (dVGE_2/dt) moyenne de variation de la tension est plus petite au moins du facteur 5 que la troisième vitesse (dVGE_3/dt) moyenne de variation de la tension.

4. Procédé suivant l'une des revendications précédentes,
**caractérisé en ce que**
- la deuxième vitesse (dVGE_2/dt) moyenne de variation de la tension est comprise entre 0 et 1 V/us.

5. Procédé suivant l'une des revendications précédentes,
**caractérisé en ce que**
- le deuxième laps de temps (t1-t2) est d'une longueur comprise entre 2 et 100 µs.

6. Procédé suivant l'une des revendications précédentes,
**caractérisé en ce que**
- la troisième valeur (V3) de tension correspond à la tension grille - émetteur du composant (703) à semiconducteur de puissance à l'état passant.

7. Procédé suivant l'une des revendications précédentes,
**caractérisé en ce que**
- la troisième valeur (V3) de tension est comprise entre 18 et 35 V.

8. Procédé suivant l'une des revendications précédentes,
**caractérisé en ce que**
- le procédé est un procédé de mise à l'état passant d'un composant (502) à semiconducteur de puissance d'un module (500) d'un onduleur (1) modulaire à plusieurs niveaux, dans lequel l'onduleur modulaire à plusieurs niveaux a une pluralité de modules (500), qui forment un circuit électrique série, les modules (500) ont chacun au moins le composant (502) à semiconducteur de puissance, un autre composant (506) à semiconducteur de puissance et un accumulateur (510) d'énergie électrique, dans lequel le composant (502) à semiconducteur de puissance et le deuxième composant (506) à semiconducteur de puissance sont montés dans un circuit en demi-pont ou les modules (600) ont respectivement au moins le composant (502) à semiconducteur de puissance, un deuxième composant (506) à semiconducteur de puissance, un troisième composant (602) à semiconducteur de puissance, un quatrième composant (606) à semiconducteur de puissance et un accumulateur (510) d'énergie électrique, dans lequel le composant (502) à semiconducteur de puissance, le deuxième composant (504) à semiconducteur de puissance, le troisième composant (602) à semiconducteur de puissance et le quatrième composant (606) à semiconducteur de puissance sont montés suivant un circuit en pont complet.

9. Procédé suivant l'une des revendications précédentes,
**caractérisé en ce que**
- la tension grille - émetteur s'élève d'un valeur (V0) de tension négative à la troisième valeur (V3) de tension, la valeur absolue de la troisième valeur (V3) de tension étant plus grande que la valeur absolue de la valeur (V0) de tension négative.

10. Procédé suivant l'une des revendications précédentes,
**caractérisé en ce que**
- le composant à semiconducteur de puissance bipolaire commutable est un transistor bipolaire à électrode (703) de grille isolée.

11. Circuit (701) de commande d'un composant (703) à semiconducteur de puissance bipolaire commutable, qui est agencé pour donner une tension grille - émetteur pour le composant (703) à semiconducteur de puissance, dans lequel
- la tension (VGE) grille - émetteur s'élève jusqu'à une première valeur (V1) de tension, dans un premier laps de temps (t0-t1), à une première vitesse (dVGE_1/dt) moyenne de variation de la tension,
- ensuite, la tension grille - émetteur, dans un deuxième laps de temps (t1-t2) reste constante ou s'élève jusqu'à une deuxième valeur (V2) de tension, dans lequel la tension grille - émetteur, dans le deuxième laps de temps, a une deuxième vitesse (dVGE_2/dt) moyenne de variation de la tension, qui est plus petite que la première vitesse (dVGE_1/dt) moyenne de variation de la tension, et
- ensuite, la tension grille - émetteur, dans un troisième laps de temps (t2-t3) s'élève jusqu'à une troisième valeur (V3) de tension à une vitesse (dVGE_3/dt) moyenne de variation de la tension, dans lequel la troisième vitesse (dVGE_3/dt) moyenne de variation de la tension est plus grande que la deuxième vitesse (dVGE_2/dt) moyenne de variation de la tension et la troisième valeur (V3) de la tension est supérieure ou égale à 18V, **caractérisé en ce que**
- pendant le deuxième laps de temps, on constate s'il passe, dans l'élément à semiconducteur de puissance, un courant d'une grande intensité inadmissible et l'on ne passe au troisième laps de temps que s'il n'a pas été constaté un courant d'une grande intensité inadmissible.

12. Circuit de commande suivant la revendication 11,
**caractérisé en ce que**
- la deuxième vitesse (dVGE_2/dt) moyenne de variation de la tension est plus petite au moins du facteur 5 que la première vitesse (dVGE_1/dt) moyenne de variation de la tension.

13. Circuit de commande suivant la revendication 11 ou 12,
**caractérisé en ce que**
- la deuxième vitesse (dVGE_2/dt) moyenne de variation de la tension est plus petite au moins du facteur 5 que la troisième vitesse (dVGE_3/dt) moyenne de variation de la tension.

14. Circuit de commande suivant l'une des revendications 11 à 13,
**caractérisé en ce que**
- la deuxième vitesse (dVGE_2/dt) moyenne de variation de la tension est comprise entre 0 et 1 V/us.

15. Circuit de commande suivant l'une des revendications 11 à 14,
**caractérisé en ce que**
- le deuxième laps de temps (t1-t2) est d'une longueur comprise entre 2 et 100 µs.

16. Circuit de commande suivant l'une des revendications 11 à 15,
**caractérisé en ce que**
- la troisième valeur (V3) de tension correspond à la tension grille - émetteur du composant (703) à semiconducteur de puissance à l'état passant.

17. Circuit de commande suivant l'une des revendications 11 à 16,
**caractérisé en ce que**
- la troisième valeur (V3) de tension est comprise entre 18 et 35 V.

18. Circuit de commande suivant l'une des revendications 11 à 17,
**caractérisé en ce que**
- la tension grille - émetteur s'élève à partir d'une valeur (V0) de tension négative jusqu'à la troisième valeur (V3) de tension, dans lequel la valeur absolue de la troisième valeur (V3) de tension est plus grande que la valeur absolue de la valeur (V0) de tension négative.

19. Circuit de commande suivant l'une des revendications 11 à 18,
**caractérisé en ce que**
- le composant à semiconducteur de puissance bipolaire commutable est un transistor bipolaire à électrode (703) de grille isolée.

20. Unité (700) à semiconducteur de puissance comprenant un composant (703) à semiconducteur de puissance bipolaire commutable, ayant notamment un transistor bipolaire à électrode de grille isolée, et un circuit (701) de commande suivant l'une des revendications 11 à 19.

21. Module (500, 600) d'un onduleur (1) modulaire à plusieurs niveaux comprenant une unité (700) à semiconducteur de puissance suivant la revendication 20.
